(19) Europäisches Patentamt
European Patent Office
Office européen des brevets

(11) **EP 2 461 384 A1**

(12) **EUROPEAN PATENT APPLICATION**
published in accordance with Art. 153(4) EPC

(43) Date of publication:
**06.06.2012 Bulletin 2012/23**

(21) Application number: **10804355.5**

(22) Date of filing: **26.07.2010**

(51) Int Cl.:
**H01L 35/14** (2006.01)   **C22C 23/00** (2006.01)
**H01L 35/34** (2006.01)   **H02N 11/00** (2006.01)

(86) International application number:
**PCT/JP2010/062509**

(87) International publication number:
**WO 2011/013609 (03.02.2011 Gazette 2011/05)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **27.07.2009 JP 2009174428**

(71) Applicants:
• **Tokyo University Of Science Educational Foundation Administrative Organization**
  **Shinjuku-ku**
  **Tokyo 162-8601 (JP)**
• **Dow Corning Toray Co., Ltd.**
  **Tokyo 100-0004 (JP)**

(72) Inventors:
• **IIDA, Tsutomu**
  **Tokyo 162-8601 (JP)**
• **FUKUSHIMA, Naoki**
  **Tokyo 1628601 (JP)**
• **SAKAMOTO, Tatsuya**
  **Tokyu 1628601 (JP)**

• **MITO, Yohiko**
  **Tokyo 1070052 (JP)**
• **NANBA, Hirokuni**
  **Kitasouma-gun**
  **Ibaraki 300-1602 (JP)**
• **TAGUCHI, Yutaka**
  **Kitasouma-gun**
  **Ibaraki 300-1602 (JP)**
• **AKASAKA, Masayasu**
  **Ichihara-shi**
  **Chiba 299-0108 (JP)**
• **TACHIKAWA, Mamoru**
  **Ichihara-shi**
  **Chiba 299-0108 (JP)**
• **HINO, Takakazu**
  **Ichihara-shi**
  **Chiba 299-0108 (JP)**

(74) Representative: **Ström & Gulliksson AB**
  **Studentgatan 1**
  **P.O. Box 4188**
  **SE-203 13 Malmö (SE)**

(54) **ALUMINUM/MAGNESIUM/SILICON COMPOSITE MATERIAL AND METHOD FOR PRODUCING SAME, THERMOELECTRIC CONVERSION MEMBER UTILIZING SAID COMPOSITE MATERIAL, THERMOELECTRIC CONVERSION ELEMENT, AND THERMOELECTRIC CONVERSION MODULE**

(57)     Disclosed is an aluminum-magnesium-silicon composite material that contains an alloy comprising Al, Mg, and Si and can be used favorably as a material for a thermoelectric conversion module, and that has excellent thermoelectric conversion properties. The aluminum-magnesium-silicon composite material contains an alloy comprising Al, Mg and Si, and has an electrical conductivity ($\sigma$) of 1000-3000 S/cm at 300 K. This aluminum-magnesium-silicon composite material is favorable in the production of a thermoelectric exchange element as a result of having excellent thermoelectric conversion properties.

FIG. 6

**Description**

TECHNICAL FIELD

The present invention relates to an aluminum-magnesium-silicon composite material; a thermoelectric conversion material, thermoelectric conversion element and thermoelectric conversion module; and a process for producing the aluminum-magnesium-silicon composite material.

BACKGROUND ART

In recent years, various means of effectively using a variety of energies have been considered in response to the heightening environmental problems. In particular, accompanying the increase in industrial waste and the like, the effective utilization of waste heat generated during the incineration of these has become an issue. For example, in a large-scale waste incineration facility, waste heat recovery is performed by generating high pressure steam from the waste heat, and generating electricity by causing a steam turbine to rotate by way of this steam. However, in a mid-to-small scale waste incineration facility, which accounts for a great majority of waste incineration facilities, the amount of waste heat exhaust is small, and thus the recovery method for waste heat of generating electricity by way of a steam turbine or the like has not been able to be employed.

As a electricity generation method using waste heat that can be employed in such mid-to-small scale waste incineration facilities, for example, methods using thermoelectric conversion materials, thermoelectric conversion elements, and thermoelectric conversion modules for reversibly performing thermoelectric conversion by utilizing the Seebeck effect or Peltier effect have been proposed.

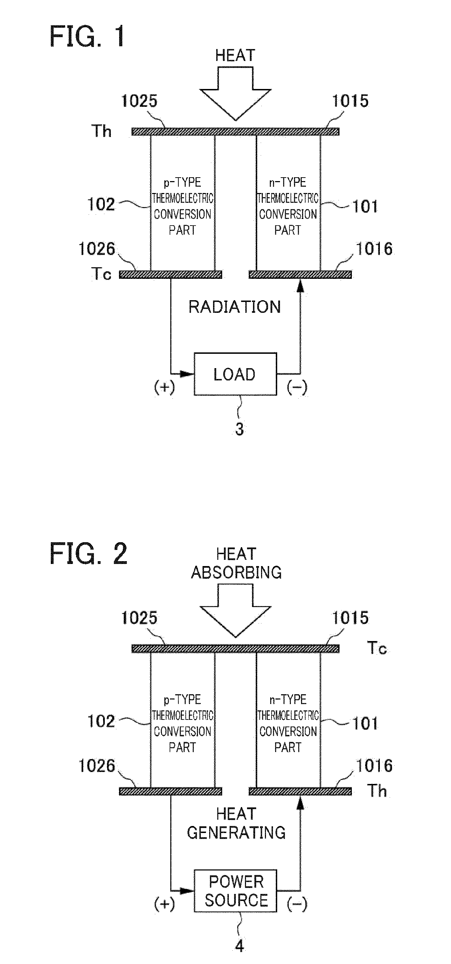

As the thermoelectric conversion module, modules such as those shown in FIGS. 1 and 2 can be exemplified, for example. In this thermoelectric conversion module, an n-type semiconductor and p-type semiconductor having low thermal conductivity are used as the thermoelectric conversion materials of the n-type thermoelectric conversion part 101 and p-type thermoelectric conversion part 102, respectively. Electrodes 1015 and 1025 are provided to the upper ends of the n-type thermoelectric conversion part 101 and the p-type thermoelectric conversion part 102 that are juxtaposed, and electrodes 1016 and 1026 are provided to the lower ends thereof, respectively. Then, the electrodes 1015 and 1025 provided to the upper ends of the n-type thermoelectric conversion part and the p-type thermoelectric conversion part are connected to form an integrated electrode, and the electrodes 1016 and 1026 provided to the lower ends of the n-type thermoelectric conversion part and the p-type thermoelectric conversion part, respectively, are configured to be separated.

Herein, as shown in FIG. 1, the side of the electrodes 1015 and 1025 is heated, and radiates from the side of the electrodes 1016 and 1026, whereby a positive temperature differential (Th-Tc) arises between the electrodes 1015, 1025 and electrodes 1016, 1026, respectively, and the p-type thermoelectric conversion part 102 becomes higher potential than the n-type thermoelectric conversion part 101 due to thermally excited carrier. At this time, current flows from the p-type thermoelectric conversion part 102 to the n-type thermoelectric conversion part 101 by connecting a resistor 3 as a load between the electrode 1016 and the electrode 1026.

On the other hand, as shown in FIG. 2, by flowing DC current from the p-type thermoelectric conversion part 102 to the n-type thermoelectric conversion part 101 using a DC power source 4, an endothermic effect arises at the electrodes 1015, 1025, and an exothermic effect arises at the electrodes 1016, 1026. In addition, by flowing a DC current from the n-type thermoelectric conversion part 101 to the p-type thermoelectric conversion part 102, an exothermic effect arises at the electrodes 1015, 1025, and an endothermic effect arises at the electrodes 1016, 1026.

As another example of a thermoelectric conversion module, modules such as those shown in FIGS. 3 and 4 can be exemplified, for example (refer to Patent Document 1, for example). In this thermoelectric conversion module, only an n-type semiconductor having low thermal conductivity is used as the thermoelectric conversion material. An electrode 1035 is provided at an upper end of the n-type thermoelectric conversion part 103, and an electrode 1036 is provided at a lower part thereof.

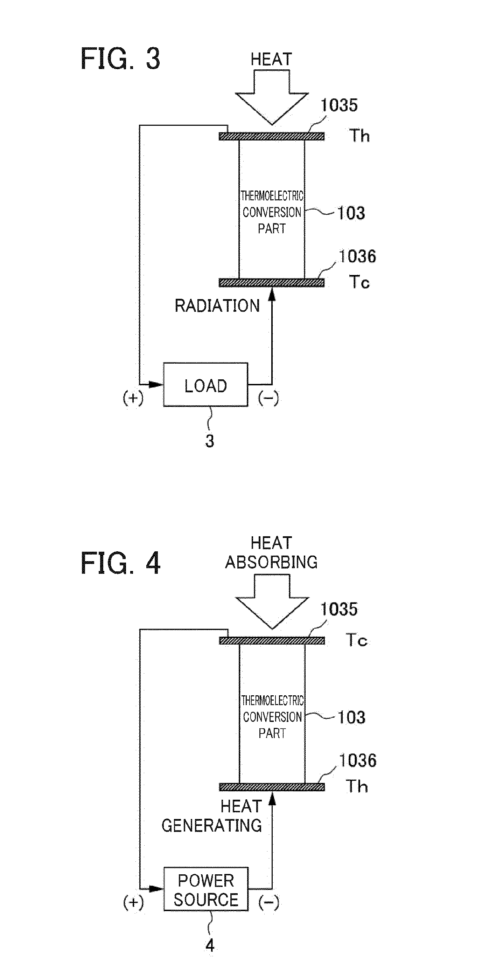

In this case, as shown in FIG. 3, the electrode 1035 side is heated, and radiates from the electrode 1036 side, whereby a positive temperature differential (Th-Tc) arises between the electrode 1035 and the electrode 1036, and the electrode 1035 side becomes higher potential than the electrode 1036 side. At this time, current flows from the electrode 1035 side to the electrode 1036 side by connecting a resistor 3 as a load between the electrode 1035 and the electrode 1036.

On the other hand, as shown in FIG. 4, by flowing DC current from the electrode 1036 side through the n-type thermoelectric conversion part 103 to the electrode 1035 side using the DC power source 4, an endothermic effect arises at the electrode 1035, and an exothermic effect arises at the electrode 1036. In addition, by flowing a DC current from the electrode 1035 side through the n-type thermoelectric conversion part 103 to the electrode 1036 side using the DC power source 4, an exothermic effect arises at the electrode 1035, and an endothermic effect arises at the electrode 1036.

Thermoelectric conversion elements that can carry out thermoelectric conversion efficiently in a remarkably simple configuration in this way have thus far been applied and developed focusing on specific purposes of use.

In this regard, attempts have thus far been made to convert to electricity utilizing a waste heat source on the order of about 200˚C to 800˚C of a fuel cell, automobile, boiler-incinerator-blast furnace or the like, using a thermoelectric conversion material such as a Bi-Te system, Co-Sb system, Zn-Sb system, Pb-Te system, and Ag-Sb-Ge-Te system. However, since toxic substances are contained in such thermoelectric conversion materials, there has been a problem in that the burden on the environment is great.

In addition, although borides containing a large amount of boron such as $B_4C$, and rare earth metal chalcogenides such as LaS have been studied as the material used in high temperature use applications, materials of non-oxide systems with an intermetallic compound such as $B_4C$ and LaS as a main constituent exhibits relatively high performance in a vacuum; however, there have been problems in that the stability in the high temperature range deteriorates with the decomposition of the crystalline phase occurring under high temperatures, or the like.

On the other hand, intermetallic compounds of silicide systems such as $Mg_2Si$ (refer to Patent Documents 2 and 3, and Non-Patent Documents 1 to 3, for example), $Mg_2Si_{1-x}C_x$ (refer to Non-Patent Document 4, for example), which have little environmental impact, have been studied.

Patent Document 1: Japanese Unexamined Patent Application, Publication No. H11-274578
Patent Document 2: Japanese Unexamined Patent Application, Publication No. 2005-314805
Patent Document 3: PCT International Publication No. WO03/027341
Non-Patent Document 1: Semiconducting Properties of Mg2Si Single Crystals, Physical Review, Vol. 109, No. 6, March 15, 1958, pp. 1909-1915
Non-Patent Document 2: Seebeck Effect in Mg2Si Single Crystals, J. Phys. Chem. Solids Program Press, 1962, Vol. 23, pp. 601-610
Non-Patent Document 3: Bulk Crystals Growth of Mg2Si by the Vertical Bridgeman Method, Science Direct Thin Solid Films, 461(2004), pp. 86-89
Non-Patent Document 4: Thermoelectric Properties of $Mg_2Si$ Crystal Grown by the Bridgeman Method

DISCLOSURE OF THE INVENTION

Problems to be Solved by the Invention

However, the above-mentioned materials containing intermetallic compounds of silicide systems containing Mg have a problem in that the thermoelectric conversion performance is low, and materials containing intermetallic compounds of silicide systems containing Mg have not actually reached practical realization in an thermoelectric conversion module.

For example, the thermoelectric performance of the magnesium-silicon composite materials described in Patent Documents 2 and 3 have not been thoroughly investigated. However, from the investigation by the present inventors, the magnesium-silicon composite materials described in Patent Documents 2 and 3 did not have the performance of a magnesium-silicon composite material that is required in the present application.

The present invention has been made taking the above issues into account, and has an object of providing an aluminum-magnesium-silicon composite material having superior thermoelectric conversion characteristics that contains an alloy of Al, Mg and Si and can be suitably employed as a material of a thermoelectric conversion module.

Means for Solving the Problems

The present inventors have carried out a thorough investigation in order to solve the above-mentioned problems. As a result thereof, it was found that an aluminum-magnesium-silicon composite material including an alloy containing Al, Mg and Si has superior thermoelectric conversion characteristics, and among the main factors deciding thermoelectric conversion performance, has a particularly high electrical conductivity, thereby arriving at completion of the present invention. More specifically, the present invention provides the following.

According to a first aspect of the present invention, an aluminum-magnesium-silicon composite material includes an alloy containing Al, Mg and Si, in which the electrical conductivity σ of the aluminum-magnesium-silicon composite material at 300 K is 1000 to 3000 S/cm.

The invention as described in the first aspect is an aluminum-magnesium-silicon composite material that includes an alloy containing Al, Mg and Si, and has high electrical conductivity. Herein, a figure-of-merit parameter indicating the thermoelectric conversion characteristics of a thermoelectric conversion material is generally derived according to the following formula (1), and the numerical value arrived at by multiplying the absolute temperature T by the above-mentioned figure-of-merit parameter is a dimensionless figure-of-merit parameter ZT.

$$Z = \alpha^2 \sigma / \kappa \qquad \cdots (1)$$

In the above formula (1), $\alpha$ indicates the Seebeck coefficient, $\sigma$ indicates the electrical conductivity, and $\kappa$ indicates the thermal conductivity.

As is evident from the above formula (1), materials having a high electrical conductivity tend to also have a high dimensionless figure-of-merit parameter. As a result, according to the invention as described in the first aspect, it is possible to obtain an aluminum-magnesium-silicon composite material that excels in thermoelectric conversion characteristics.

It should be noted that the composite material of the invention as described in the first aspect includes an "alloy containing Al, Mg and Si", and differs from a material containing aluminum on the extent of an impurity, arrived at by doping aluminum in a magnesium silicide such as $Mg_2Si$, for example. In the present invention, the above-mentioned composite material indicates a material having a content of Al element of at least 0.5 at%.

According to a second aspect of the present invention, the aluminum-magnesium-silicon composite material as described in the first aspect is synthesized from a starting material composition, which is obtained by mixing a Mg alloy containing Al and/or a mixture of Al and Mg with Si, and has a content of Al of 1 to 10 at%.

The invention as described in the second aspect defines the starting material composition upon producing the aluminum-magnesium-silicon composite material described in the first aspect. Therefore, according to the invention as described in the second aspect, it is possible to obtain similar effects to the invention as described in the first aspect.

According to a third aspect of the present invention, in the aluminum-magnesium-silicon composite material as described in the second aspect, the content of Al in the starting material composition is 3.5 to 6.0 at%.

The invention as described in the third aspect defines the preferred content of Al in the starting material composition upon producing the aluminum-magnesium-silicon composite material as described in the second aspect. According to the invention as described in the third aspect, in addition to the effects of the invention as described in the second aspect, it is possible to obtain an effect of excelling in the mechanical strength of the sintered body.

According to a fourth aspect of the present invention, a process for producing an aluminum-magnesium-silicon composite material includes a step of heating and melting a starting material composition, which is obtained by mixing a Mg alloy containing Al and/or a mixture of Al and Mg with Si, and has a content of Al of 1 to 10 at%, in a heat-resistant container including an opening portion and a lid portion covering the opening portion, wherein a contacting surface of an edge of the opening portion to the lid portion and a contacting surface of the lid portion to the opening portion have both been polished.

The invention as described in the fourth aspect defines the invention as described in the first or second aspect as an invention of a production process. Therefore, according to the invention as described in the fourth aspect, it is possible to obtain similar effects to the invention as described in the first or second aspect.

According to a fifth aspect of the present invention, a thermoelectric conversion material includes the aluminum-magnesium-silicon composite material as described in any one of the first to third aspects.

According to a sixth aspect of the present invention, a thermoelectric conversion element includes: a thermoelectric conversion part; and a first electrode and a second electrode provided to the thermoelectric conversion part, in which the thermoelectric conversion part is produced using the aluminum-magnesium-silicon composite material as described in any one of the first to third aspects.

According to a seventh aspect of the present invention, a thermoelectric conversion module includes the thermoelectric conversion element as described in the sixth aspect.

The inventions as described in the fifth to seventh aspects define the invention as described in any one of the first to third aspects as inventions of a thermoelectric conversion material, thermoelectric conversion element, and thermoelectric conversion module. Therefore, according to the inventions as described in the fifth to seventh aspects, it is possible to obtain similar effects to the invention as described in any one of the first to third aspects.

According to an eighth aspect of the present invention, a corrosion-resistant material, a light-weight structural material, a friction material, a ceramic substrate, a dielectric porcelain composition, a hydrogen storage composition, or a silane generator is produced using the aluminum-magnesium-silicon composite material as described in any one of the first to third aspects.

As the application of the magnesium-silicon composite material according to the present invention, the applications of a thermoelectric conversion material, thermoelectric conversion element and thermoelectric conversion module can be preferably exemplified; however, it can also be used in applications such as a corrosion-resistant material, a light-weight structural material, a friction material, a ceramic substrate, a dielectric porcelain composition, a hydrogen storage composition, and a silane generator, for example.

Effects of the Invention

The aluminum-magnesium-silicon composite material according to the present invention is an aluminum-magnesium-silicon composite material having high electrical conductivity that includes an alloy containing Al, Mg and Si. Herein, a material having high electrical conductivity σ tends to also have a high figure-of-merit parameter; therefore, according to the present invention, it is possible to obtain an aluminum-magnesium-silicon composite material excelling in thermoelectric conversion characteristics.

BRIEF DESCRIPTION OF THE DRAWINGS

FIG. 1 is a view showing an example of a thermoelectric conversion module;
FIG. 2 is a view showing an example of a thermoelectric conversion module;
FIG. 3 is a view showing an example of a thermoelectric conversion module;
FIG. 4 is a view showing an example of a thermoelectric conversion module;
FIG. 5 is a view showing an example of a sintering device;
FIG. 6 is a graph showing the relationship between the temperature and the dimensionless figure-of-merit parameter of aluminum-magnesium-silicon composite materials according to the present invention;
FIG. 7 is a graph showing the relationship between the electrical conductivity and the compositional ratio of aluminum for aluminum-magnesium-silicon composite materials according to the present invention;
FIG. 8 is a graph showing the relationship between the dimensionless figure-of-merit parameter and the electrical conductivity for aluminum-magnesium-silicon composite materials according to the present invention;
FIG. 9 is a graph showing the relationship between the dimensionless figure-of-merit parameter and the compositional ratio of aluminum for the aluminum-magnesium-silicon composite material according to the present invention; and
FIG. 10 is a graph showing the relationship between the compressive strength and the compositional ratio of aluminum for the aluminum-magnesium-silicon composite material according to the present invention.

EXPLANATION OF REFERENCE NUMERALS

101 n-type thermoelectric conversion part
1015, 1016 electrode
102 p-type thermoelectric conversion part
1025, 1026 electrode
103 n-type thermoelectric conversion part
1035, 1306 electrode
3 load
4 DC power source
10 graphite die
11a, 11b punch made of graphite

PREFERRED MODE FOR CARRYING OUT THE INVENTION

Hereinafter, embodiments of the present invention will be explained in detail by providing drawings.

[Aluminum-magnesium-silicon Composite Material]

(Characteristics of Aluminum-magnesium-silicon composite material)

The aluminum-magnesium-silicon composite material according to the present invention includes an alloy containing Al, Mg and Si, and has an electrical conductivity σ at 300 K of 1000 to 3000 S/cm. Herein, as is evident from the above formula (1) showing the figure-of-merit parameter of a thermoelectric conversion material, a material for which the electrical conductivity σ is high tends to also have a high figure-of-merit parameter. As a result, the aluminum-magnesium-silicon composite material according to the present invention tends to have superior thermoelectric conversion performance. From the aluminum-magnesium-silicon composite material exhibiting superior electrical conductivity, it is possible to obtain high thermoelectric conversion performance in a case of using the aluminum-magnesium-silicon composite material in a thermoelectric conversion element or thermoelectric conversion module, for example. It should be noted that the above electrical conductivity is preferably 1100 to 2500 S/cm, and more preferably 1200 to 2000 S/cm.

Herein, the aluminum-magnesium-silicon composite material according to the present invention may be the material after heating and melting the starting material composition, and preferably the material after pulverizing the sample after heating and melting, or may be the material after sintering the sample after pulverizing; however, when referring to the electrical conductivity of the aluminum-magnesium-silicon composite material, it is intended to indicate a material measured after heating and melting the starting material composition containing Al, Mg and Si, and pulverizing the sample after heating and melting, and sintering the pulverized sample. Similarly, when referring the dimensionless figure-of-merit parameter of the aluminum-magnesium-silicon composite material, it is intended to indicate a material measured after heating and melting the starting material composition containing Al, Mg and Si, and pulverizing the sample after heating and melting, and sintering the pulverized sample.

In other words, the aluminum-magnesium-silicon composite material according to the present invention has a meaning encompassing the heated and melted material of the starting material composition, the pulverized material of this heated and melted material, and the sintered body of the pulverized material; this heated and melted material, pulverized material, and sintered body each independently have value as commercial products. The thermoelectric conversion material itself and the thermoelectric conversion parts constituting the thermoelectric conversion element according to the present invention are configured from this sintered body.

As described above, the aluminum-magnesium-silicon composite material according to the present invention includes an "alloy containing Al, Mg and Si", and differs from a material containing Al on the extent of an impurity, arrived at by doping Al in a magnesium silicide such as $Mg_2Si$, for example. The above-mentioned composite material of the present invention usually indicates a material having a content of Al of at least 0.5 at%.

In addition, the aluminum-magnesium-silicon composite material according to the present invention preferably has a dimensionless figure-of-merit parameter at 860 K of at least 0.47, and more preferably at least 0.55. By way of the dimensionless figure-of-merit parameter being within the above range, it is possible to obtain superior thermoelectric conversion performance when the aluminum-magnesium-silicon composite material is used as a thermoelectric conversion material.

It should be noted that the aluminum-magnesium-silicon composite material according to the present invention may be of any form such as a material of ingot form, a material of powder form, and a sintered material of powder form; however, being a material arrived at by sintering a material of powder form is preferable. Furthermore, as an application for the aluminum-magnesium-silicon composite material according to the present invention, applications as a thermoelectric conversion material, thermoelectric conversion element and thermoelectric conversion module described later can be exemplified; however, it is not limited to such applications, and can be used in applications such as a corrosion-resistant material, light-weight structural material, friction material, ceramic substrate, dielectric porcelain composition, hydrogen storage composition, and silane generator.

Furthermore, the aluminum-magnesium-silicon composite material according to the present invention excels in mechanical strength. As a result, the aluminum-magnesium-silicon composite material according to the present invention can be easily worked into a thermoelectric conversion element or the like.

[Thermoelectric Conversion Material, Thermoelectric Conversion Element, and Thermoelectric Conversion Module]

The aluminum-magnesium-silicon composite material according to the present invention can be suitably employed as a thermoelectric conversion material. In other words, the aluminum-magnesium-silicon composite material according to the present invention has electrical conductivity at 300 K of 1000 to 3000 S/cm; therefore, it tends to excel in thermoelectric conversion performance, and thus it is possible to obtain high thermoelectric conversion performance in a case of employing this in a thermoelectric conversion element or thermoelectric conversion module as a thermoelectric conversion material.

[Process for Producing Aluminum-magnesium-silicon Composite Material, Etc.]

The process for producing the aluminum-magnesium-silicon composite material according to the present invention includes a step of heating and melting a starting material composition, which was obtained by mixing a Mg alloy containing Al, and/or a mixture of Al and Mg, with Si has a content of Al of 1 to 10 at% by atomic weight, in a heat-resistant container having an opening portion and a lid portion that covers this opening portion, in which a contacting surface at an edge of the above-mentioned opening portion to the above-mentioned the lid portion and a contacting surface of the above-mentioned lid portion to the above-mentioned opening portion have both undergone polishing processing.

In addition, the process for producing the aluminum-magnesium-silicon composite material according to the present invention preferably includes a step of pulverizing the sample obtained in the heating and melting step, and sintering the above pulverized sample.

It should be noted that the content of Al in the starting material composition is more preferably 3.5 to 6.0 at%, and still more preferably 3.8 to 5.8 at%. By setting the content of Al to such a range, it will excel in mechanical strength of the sintered body. Therefore, it is possible to prevent the element from breaking also upon cutting the sintered body to the desired size by way of a blade saw, for example.

(Mixing Step)

In the mixing step, a Mg alloy containing Al, and/or a mixture of Al and Mg are mixed with Si to obtain a starting material composition in which the content of Al is 1 to 10 at%, more preferably 3.5 to 6.0 at%, and still more preferably 3.8 to 5.8 at%.

Silicon of at least 3N, and preferably 6N can be employed as the Si. More specifically, herein, high-purity silicon feedstock for LSI, high-purity silicon feedstock for photovoltaic cells, high-purity metallic silicon, high-purity silicon ingot, high-purity silicon wafer, and the like can be exemplified as the high purity silicon.

In a case of using a mixture of Al and Mg as the raw material of Al and Mg in the mixing step, the Mg has a purity at least on the order of 99.5 wt%, and so long as not substantially containing impurities, is not particularly limited; however, it is permissible even if containing impurities such as Si, Mn, Al, Fe, Cu, Ni and Cl.

In addition, in a case of using a mixture of Al and Mg as the raw material of Al and Mg in the mixing step, the Al has a purity at least on the order of 99.5 wt%, and so long as not substantially containing impurities, is not particularly limited; however, it is permissible even if containing impurities such as Si, Mn, Mg, Fe, Cu, Ni and Cl, for example.

Furthermore, in a case of using a Mg alloy containing Al as the raw material of Al and Mg in the mixing step, an alloy can be exemplified that contains 2.0 to 8.2 at% Al, preferably 3.5 to 6.0 at%, and more preferably 3.8 to 5.8 at%. More specifically, AM20, AZ31B, AM60B and AZ91D can be exemplified as such an alloy. Such an alloy is recyclable from various products on the market; therefore, it is possible to reduce the production cost of the aluminum-magnesium-silicon composite material.

In the starting material composition obtained in the mixing step, the content of Mg is 66.17 to 66.77 at% by atomic weight ratio based on the total content of Mg and Si, and the content of Si is 33.23 to 33.83 at% by atomic weight ratio based on the total content of Mg and Si.

It should be noted that the content of Mg is preferably 66.27 to 66.67 at% by atomic weight ratio based on the total content of Mg and Si, the content of Si in this case is preferably 33.33 to 33.73 at% by atomic weight ratio based on the total content of Mg and Si.

(Heating and Melting Step)

In the heating and melting step, it is preferable to heat treat the starting material composition containing Al, Mg and Si under a reducing atmosphere and preferably under vacuum, under temperature conditions exceeding the melting points of Mg and Al and falling below the melting point of Si, to synthesize an alloy containing Al, Mg and Si by melting. Herein, "under a reducing atmosphere" indicates an atmosphere particularly containing at least 5% by volume of hydrogen gas, and containing inert gas(es) as the other component(s) as necessary. By performing the heating and melting step under such a reducing atmosphere, the Mg, Al and Si can be reliably made to react, and thus an aluminum-magnesium-silicon composite material can be synthesized.

As the pressure condition in the heating and melting step, although it may also be at atmospheric pressure, $1.33 \times 10^{-3}$ Pa to atmospheric pressure is preferable, and if taking safety into consideration, it is preferably set to reduced pressure conditions on the order of 0.08 MPa, for example.

In addition, as the heating conditions in the heating and melting step, it is possible to conduct heat treatment for on the order of 3 hours from at least 700˚C to less than 1410˚C, and preferably at least 1085˚C to less than 1410˚C, for example. Herein, the time of heat treatment may be 2 to 10 hours. By setting the heat treatment to a long time, it is possible to further homogenize the aluminum-magnesium-silicon composite material obtained. It should be noted that the melting point of Al is 660.4˚C, and the melting point of Si is 1410˚C.

Herein, in a case of Mg being melted by heating to at least 693˚C, which is the melting point of Mg, although Al and Si will start to react by melting thereinto, the reaction rate will be somewhat slow. On the other hand, in a case of heating to at least 1090˚C, which is the boiling point of Mg, although the reaction rate will be high, Mg will suddenly vaporize and may disperse; therefore, it is necessary to synthesize with caution.

In addition, as the temperature rise condition upon heat treating the starting material composition, for example, a temperature rise condition of 150 to 250˚C/hour until reaching 150˚C and a temperature rise condition of 350 to 450˚C/hour until reaching 1100˚C can be exemplified, and as a temperature decline condition after heat treatment, a temperature decline condition of 900 to 1000˚C/hour can be exemplified.

It should be noted that, when performing the heating and melting step, it is necessary to be performed inside of a heat-insulated container including an opening potion and a lid portion covering this opening portion, and in which the contacting surface of the edge of the above-mentioned opening portion to the above-mentioned lid portion, and the contacting surface of the above-mentioned lid portion to the above-mentioned opening portion have both undergone polishing processing. By performing polishing processing in this way, it is thereby possible to obtain an aluminum-magnesium-silicon composite material having component proportions close to the component proportions of the starting material composition. This is considered to be due to gaps not forming at the contacting surface between the above-mentioned lid portion and the edge of the above-mentioned opening portion, and the heat-resistant container being sealed; therefore, the dispersion of vaporized Mg or Al to outside the heat-resistance container can be suppressed.

The polishing processing of the contacting surface of the edge of the above-mentioned opening portion to the above-mentioned lid portion, and the contacting surface of the above-mentioned lid portion to the above-mentioned opening portion is not particularly limited, and just needs to provide a polished surface. However, setting the surface roughness Ra of this contacting surface to 0.2 to 1 $\mu$m is particularly preferable to form a close-contacting state, and setting to 0.2 to 0.5 $\mu$m is more preferable. If the surface roughness exceeds 1 $\mu$m, the contact between the edge of the opening portion and the lid portion may be insufficient. On the other hand, in a case of the surface roughness Ra being less than 0.2 $\mu$m, grinding more than what is necessary will have been performed, and is not preferable from a cost perspective. In addition, the above-mentioned contacting surfaces preferably have a surface waviness Rmax of 0.5 to 3 $\mu$m, and more preferably 0.5 to 1 $\mu$m. In a case of the surface waviness being less than 0.5 $\mu$m, polishing more than what is necessary will have been performed, and is not preferable from a cost perspective.

Herein, as such a heat-insulated container, a sealed container can be exemplified that is composed of alumina, magnesia, zirconia, platinum, iridium, silicon carbide, boron nitride, pyrolytic boron nitride, pyrolytic graphite, pyrolytic boron nitride coat, pyrolytic graphite coat, and quartz. In addition, as the dimensions of the above-mentioned heat-insulated container, a container can be exemplified in which the vessel main body is 12 to 300 mm in inside diameter, 15 to 320 mm in outside diameter, 50 to 250 mm in height, and the diameter of the lid portion is 15 to 320 mm.

Furthermore, in order to closely contact the contacting surface of the edge of the above-mentioned opening portion to the above-mentioned lid portion and the contacting surface of the above-mentioned lid portion to the above-mentioned opening portion, it is possible to directly or indirectly pressurize the top surface of the above-mentioned lid portion by weight as necessary. The pressure during this pressurization is preferably 1 to 10 kgf/cm$^2$.

As the gas used in order to perform the heating and melting step under a reducing atmosphere, although it may be 100% by volume hydrogen gas, a mixed gas of hydrogen gas and inert gas such as nitrogen gas or argon gas containing 5% by volume hydrogen gas can be exemplified. The reason for performing the heating and melting step under a reducing atmosphere in this way can be given that, upon producing the aluminum-magnesium-silicon composite material according to the present invention, there is a necessity to avoid as much as possible not only the generation of silicon oxide, but also magnesium oxide.

The sample thus heated and melted can be cooled by natural cooling or forced cooling.

(Pulverizing Step)

The pulverizing step is a step of pulverizing a sample that has been heated and melted. In the pulverizing step, the sample that has been heated and melted is preferably pulverized into fine particles having a narrow particle size distribution. By pulverizing into fine particles having a narrow particle size distribution, pulverized particles fuse at least at a portion of the surfaces thereof upon sintering this, and thus it is possible to sinter to an extent at which the occurrence of gaps (voids) are almost not observed, and a sintered body can be obtained having a density of substantially the same degree as the theoretical value from about 70% of the theoretical value.

As the above-mentioned sample that has been pulverized, that having a mean particle size of 0.1 to 100 $\mu$m can be preferably used. More specifically, particles passing through a 75 $\mu$m sieve can be used.

It should be noted that, in a case of employing the aluminum-magnesium-silicon composite material according to the present invention, doping may be performed in the sintering step by adding a dopant in a predetermined amount after the pulverizing step.

Trivalent dopants such as boron, gallium and indium doping a divalent Mg site; and pentavalent dopants such as phosphorus and bismuth doping a quadrivalent Si site can be exemplified as specific examples of the dopant, for example. It is possible to produce an aluminum-magnesium-silicon composite material to be used as an n-type thermoelectric conversion material by adding at least one type of these dopants in the required amount.

In addition, monovalent dopants such as Ag, Cu and Au doping a divalent Mg site; and trivalent dopants such as gallium and indium doping a quadrivalent Si site can be exemplified as other specific examples of the dopant, for example. It is possible to produce an aluminum-magnesium-silicon composite material to be used as a p-type thermoelectric conversion material by adding at least one type of these dopants in the required amount.

Concerning the dopant, so long as a sintered body that can stably exhibit high thermoelectric conversion performance is obtained by performing pressurized sintering, a dopant that is doped by melting into the aluminum-magnesium-silicon composite material from a reactor or the like used while sintering $Mg_2Si$ may be the entirety of the dopant of the sintered body, or may be a portion of the dopant of the sintered body.

It should be noted that, generally, in a case of adding the dopant in the heating and melting step, it is allowable until a solid solution critical concentration under thermal equilibrium conditions; however, in the case of performing doping in the sintering step described later, an addition of dopant can be made that exceeds the solid solution critical concentration.

(Sintering Step)

The sintering step is a step of sintering the above-mentioned pulverized sample. As the conditions of sintering in the sintering step, a method of sintering the above-mentioned sample to which a dopant may have been added under vacuum or at a reduced pressure atmosphere at a sintering pressure of 5 to 60 MPa and at a sintering temperature of 600 to 1000˚C, by a pressurized sintering method can be exemplified.

In a case of the sintering pressure being less than 5 MPa, it becomes difficult to obtain a sintered body having an adequate density of at least about 70% of the theoretical density, and the sample obtained may not be able to be practiced in view of strength. On the other hand, a case of the sintering pressure exceeding 60 MPa is not preferable from a cost perspective, and thus is not practical. In addition, with the sintering temperature less than 600˚C, it becomes difficult to obtain a sintered body having a density from 70% of the theoretical density to nearly the theoretical density in which at least a part of the faces at which particles contact with each other fuse and are calcined, and the obtained sample may not be able to be practiced in view of strength. In addition, in a case of the sintering temperature exceeding 1000˚C, not only will damage to the sample occur due to too high a temperature, but depending on the case, Mg may suddenly vaporize and disperse.

As specific sintering conditions, for example, sintering conditions can be exemplified in which the sintering temperature is set within the range of 600 to 800˚C, and when the sintering temperature is at a temperature near 600˚C, the sintering pressure is set to a pressure near 60 MPa, and when the sintering temperature is a temperature near 800˚C, the sintering pressure is set to a pressure near 5 MPa, and sintered for approximately 5 to 60 minutes, preferably 10 minutes. By performing sintering under such sintering conditions, it is possible to obtain a sintered body that has high mechanical strength and density substantially equivalent to the theoretical density, and can stably exhibit high thermoelectric conversion performance.

In addition, in a case of performing the sintering step under an environment in which air is present, it is preferable to sinter under an atmosphere using an inert gas such as nitrogen or argon.

In a case of using a pressurized sintering method in the sintering step, the hot-press sintering method (HP), hot isostatic press sintering method (HIP) and spark plasma sintering method can be employed. Among these, the spark plasma sintering method is preferable.

The spark plasma sintering method, in one type of pressurized sintering method using a DC pulse electric current method, and is a method of heating and sintering by passing a pulse of high current through various materials, and in principle, is a method of flowing current through conductive materials such as graphite, and processing and treating a material by way of Joule heating.

The sintered body obtained thereby is a sintered body that has high mechanical strength and can stably exhibit high thermoelectric conversion performance, and can be used as a thermoelectric conversion material excelling in durability without weathering, and excelling in stability and reliability.

(Thermoelectric Conversion Element)

The thermoelectric conversion element according to the present invention includes a thermoelectric conversion part, and a first electrode and a second electrode provided to this thermoelectric conversion part, and this thermoelectric conversion part is produced using the aluminum-magnesium-silicon composite material according to the present invention.

(Thermoelectric Conversion Part)

As the thermoelectric conversion part, a part made by cutting the sintered body obtained in the above sintering step to a desired size using a wire saw or the like can be used.

This thermoelectric conversion part is usually producing using one type of thermoelectric conversion material; however, it may be made as a thermoelectric conversion part having a multi-layer structure using a plurality of types of thermoelectric conversion materials. A thermoelectric conversion part having a multi-layer structure can be produced by laminating a plurality of types of thermoelectric conversion materials prior to sintering in a desired order, and then sintering.

(Electrode)

Although the formation method of the above-mentioned first electrode and second electrode is not particularly limited, being able to form the electrode by a plating method is one of the characteristics of the thermoelectric conversion element produced using the aluminum-magnesium-silicon composite material according to the present invention.

Normally, in a case of attempting to form an electrode by a plating method on a thermoelectric conversion part produced using an aluminum-magnesium-silicon composite material, hydrogen gas evolves due to metallic magnesium remaining in the material, and the adhesiveness of the plating deteriorates. On the other hand, in a case of a thermoelectric conversion part produced using the aluminum-magnesium-silicon composite material according to the present invention, almost no metallic magnesium is contained in the material; therefore, it is possible to form electrodes having high adhesiveness by a plating method. Although the plating method is not particularly limited, electroless nickel plating is preferable.

In a case of there being unevenness that becomes a hindrance to performing plating on the surface of the sintered body prior to forming the electrode by a plating method, it is preferable to smooth by polishing.

A thermoelectric conversion element including the first electrode, thermoelectric conversion part and second electrode is prepared by cutting the sintered body with the plated layer obtained in this way to a predetermined size using a cutter such as that of a wire saw or saw blade.

In addition, the first electrode and the second electrode can be formed to be integrated during sintering of the aluminum-magnesium-silicon composite material. In other words, by layering the electrode material, aluminum-magnesium-silicon composite material and electrode material in this order, and then performing pressurized sintering, it is possible to obtain a sintered body in which electrodes are formed at both ends.

Two methods will be explained as formation methods of the electrode by a pressurized sintering method in the present invention.

The first method layers, to a predetermined thickness, a layer of an insulating material powder such as of $SiO_2$, a layer of metal powder for electrode formation such as of Ni, a layer of pulverized product of the aluminum-magnesium-silicon composite material according to the present invention, a layer of the above-mentioned metal powder for electrode formation, and a layer of the above-mentioned insulating material powder, inside of a cylindrical-type sintering tool composed of a graphite die and a punch made of graphite, for example, in sequence from a base thereof, followed by performing pressurized sintering.

The above-mentioned insulating material powder prevents electricity from flowing from the sintering device to the metallic powder for electrode formation, and thus effective in preventing melting, and the insulating material is separated from the electrodes formed after sintering.

In the first method, once carbon paper is interposed between the insulating material powder layer and the metallic powder for electrode formation layer, and carbon paper is further placed at the interior wall surface of the cylindrical-type sintering tool, it is effective in preventing the mixing of powders and in separating the electrodes and insulating material layer after sintering.

Since many irregularities are formed on the top and bottom surface of the sintered body obtained in this way, it is necessary to smooth by polishing, followed by cutting to a predetermined size using a cutter such as that of a wire saw or saw blade, whereby a thermoelectric conversion element including the first electrode, thermoelectric conversion part, and second electrode is prepared.

According to a conventional method not using an insulating material powder, the metallic powder for electrode formation will be melted by the current; therefore, it is difficult to adjust the current without being able to use high current, and consequently there has been a problem in that the electrodes will peel off from the sintered body obtained. On the other hand, in the first method, high current can be used due to providing the insulating material powder, a result of which it is possible to obtain a desired sintered body.

The second method does not use the above-mentioned insulating material powder layer of the above first method, and layers a layer of a metallic powder for electrode formation such as of Ni, a layer of pulverized product of the aluminum-magnesium-silicon composite material of the present invention, and a layer of the above-mentioned metallic powder for electrode formation, inside of a cylindrical-type sintering tool in sequence from the base thereof, then coats or sprays insulating, heat-resistant, and mold releasing ceramic particles such as of BN onto the surface of the above-mentioned graphite die of the sintering tool contacting the layer of the above-mentioned metallic powder for electrode formation, and then performs pressurized sintering. In this case, it is not necessary to use carbon paper as in the first method.

In addition to having all of the advantages of the first method, this second method has an advantage in that polishing is almost unnecessary since the top and bottom surfaces of the sintered body obtained are smooth.

The method of cutting the sintered body obtained to a predetermined size to prepare the thermoelectric conversion element including the first electrode, thermoelectric conversion part and second electrode is the same as the above-mentioned first method.

(Thermoelectric Conversion Module)

The thermoelectric conversion module according to the present invention is equipped with the thermoelectric conversion element according to the present invention such as that described above.

As one example of a thermoelectric conversion module, modules such as those shown in FIGS. 1 and 2 can be exemplified, for example. With these thermoelectric conversion module, an n-type semiconductor and a p-type semiconductor obtained from the aluminum-magnesium-silicon composite material according to the present invention are used as the thermoelectric conversion materials of an n-type thermoelectric conversion part 101 and a p-type thermoelectric conversion part 102, respectively. Electrodes 1015 and 1025 are provided to the upper ends of the n-type thermoelectric conversion part 101 and the p-type thermoelectric conversion part 102, which are juxtaposed, and electrodes 1016 and 1026 are provided to the lower ends thereof, respectively. Then, the electrodes 1015 and 1025 provided to the upper ends of the n-type thermoelectric conversion part and the p-type thermoelectric conversion part are connected to form an integrated electrode, and the electrodes 1016 and 1026 provided to the lower ends of the n-type thermoelectric conversion part and the p-type thermoelectric conversion part, respectively, are configured to be separated.

In addition, as another example of a thermoelectric conversion module, modules such as those shown in FIGS. 3 and 4 can be exemplified, for example. With these thermoelectric conversion modules, an n-type semiconductor obtained from the aluminum-magnesium-silicon composite material according to the present invention is used as the thermoelectric conversion material of an n-type thermoelectric conversion part 103. An electrode 1035 is provided to an upper end of the n-type thermoelectric conversion part 103, and an electrode 1036 is provided to the lower part thereof.

The aluminum-magnesium-silicon composite material according to the present invention is an aluminum-magnesium-silicon composite material having high electrical conductivity that includes an alloy containing Al, Mg and Si. Herein, a material having high electrical conductivity σ tends to also have a high dimensionless figure-of-merit parameter; therefore, according to the present invention, it is possible to obtain an aluminum-magnesium-silicon composite material excelling in thermoelectric conversion characteristics.

EXAMPLES

Hereinafter, the present invention will be explained in detail by providing Examples. It should be noted that the present invention is not to be limited in any way to the Examples shown hereinafter.

Test Example 1: Measurement of Thermoelectric Characteristics

[Example 1]

(Mixing Step)

A starting material composition having a compositional ratio of Mg to Si of Mg:Si = 66.0:33.0 and Al content of 1.0 at% (1.0 at% Al, 66.0 at% Mg, 33.0 at% Si) was obtained by mixing 36.23 parts by mass of high purity silicon, 62.72 parts by mass of magnesium and 1.06 parts by mass of aluminum. It should be noted that, as the high-purity silicon, granular silicon of semiconductor grade having a purity of 99.9999999% and no more than 4 mm diameter manufactured by MEMC Electronic Materials Corp. was used. In addition, as the magnesium, magnesium pieces having a purity of 99.93% and size of 1.4 mm$\times$ 0.5 mm manufactured by Nippon Thermochemical Co. Ltd. were used. Furthermore, as the aluminum, chip-shaped aluminum having a purity of 99.99% and size of 3 to 7 mm manufactured by Furuuchi Chemical Corp. was used.

(Heating and Melting Step)

The above-mentioned starting material composition was charged into a melting crucible made of $Al_2O_3$ (manufactured by Nihon Kagaku Togyo Kabushiki Kaisha, 34 mm inside diameter, 40 mm outside diameter, 150 mm height; lid portion, 40 mm diameter, 2.5 mm thickness). As this melting crucible, one was used in which the contacting surface of the edge of the opening portion to the lid portion and the contacting surface of the lid portion to the edge of the opening portion have been polished so as to have a surface roughness Ra of 0.5 $\mu$m and a surface waviness Rmax of 1.0 $\mu$m. The edge of the opening portion of the melting crucible and the lid portion were made to closely contact, left to stand inside a heating furnace, and then the pressure was increased with weight via ceramic rods from outside of the heating furnace so as to be 3 kgf/cm$^2$.

Next, the inside of the heating furnace was decompressed with a rotary pump until no more than 5 Pa, and then decompressed until $1.33\times10^{-2}$ Pa with a diffusion pump. In this state, the inside of the heating furnace was heated at 200˚C/hour until reaching 150˚C, and then maintained at 150˚C for 1 hour to dry the starting material composition.

At this time, mixed gas of hydrogen gas and argon gas filled inside of the heating furnace, with the partial pressure of hydrogen gas being 0.005 MPa and the partial pressure of argon gas being 0.052 MPa.

Thereafter, it was heated at 400˚C/hour until reaching 1100˚C, and then maintained at 1100˚C for 3 hours. Subsequently, it was cooled at 100˚C/hour until 900˚C, and then cooled at 1000˚C/hour until room temperature.

(Pulverizing Step and Sintering Step)

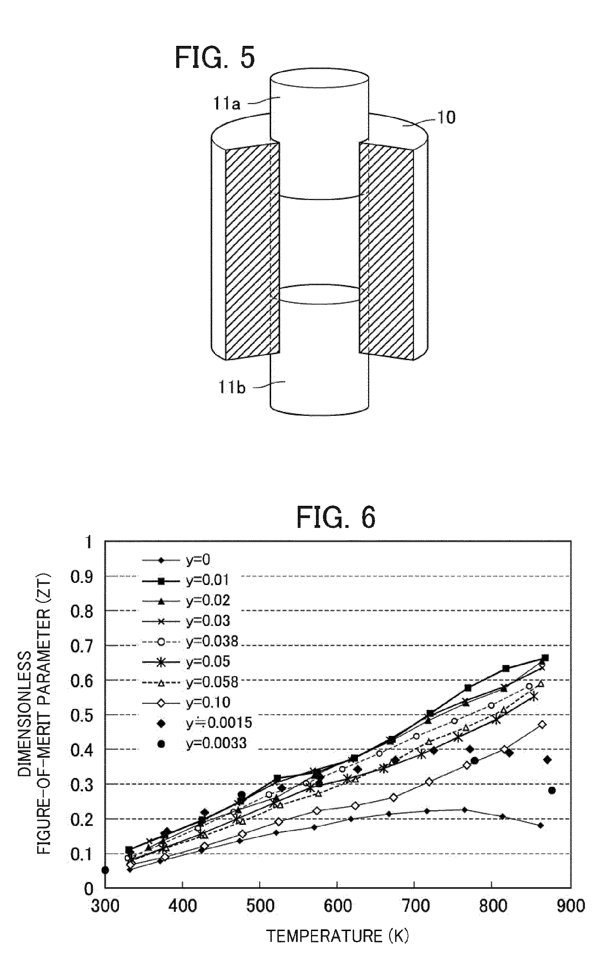

The sample after heating and melting was pulverized until 75 $\mu$m using a ceramic mortar to obtain a fine powder passing through a 75 $\mu$m sieve. Then, 1.0 gram of the magnesium-silicon composite material thus pulverized was loaded in a space enclosed by a graphite die 10 of 15 mm inside diameter and punches 11a, 11b made of graphite, as shown in FIG. 5. In order to prevent adhering of the magnesium-silicon composite material to the punches, carbon paper was interposed between the top and bottom ends of the fine powder. Thereafter, sintering was performed under an argon atmosphere using a spark plasma sintering apparatus ("PAS-III-Es" manufactured by ELENIX Co., Ltd.) to obtain a sintered body. The sintering conditions were as follows.

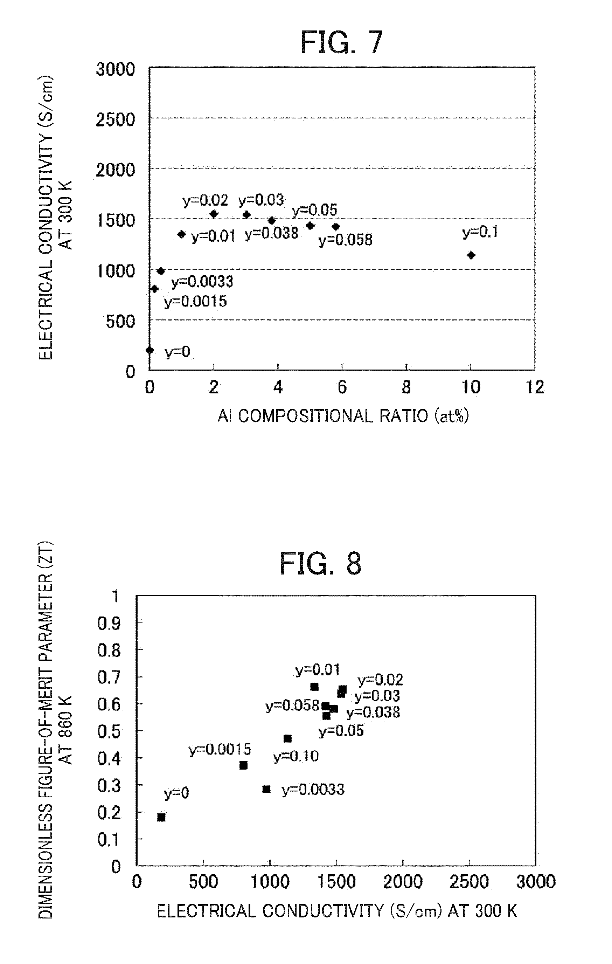

Sintering temperature: 750˚C
Pressure: 30.0 MPa
Temperature rising rate: 100˚C/min $\times$ 5 min (to 500˚C)
0˚C/min $\times$ 10 min (500˚C)
20˚C/min $\times$ 12.5 min (500˚C to 750˚C)
0˚C/min $\times$ 2 min (750˚C)
Cooling conditions: vacuum cooling
Atmosphere: Ar 60 Pa (vacuum during cooling)
It should be noted that the samples derived from the present Example are indicated by y=0.01 in FIGS. 6 to 9.

[Example 2]

An aluminum-magnesium-silicon composite material (sintered body) was obtained by the same method as Example 1, except for the aspect of setting the added amount of aluminum to 2.11 parts by mass, and thus setting the content of aluminum in the starting material composition to 2.0 at%, in the mixing step.
It should be noted that the samples derived from the present Example are indicated by y=0.02 in FIGS. 6 to 9.

[Example 3]

An aluminum-magnesium-silicon composite material (sintered body) was obtained by the same method as Example 1, except for the aspect of setting the added amount of aluminum to 3.16 parts by mass, and thus setting the content of aluminum in the starting material composition to 3.0 at%, in the mixing step.
It should be noted that the samples derived from the present Example are indicated by y=0.03 in FIGS. 6 to 9.

[Example 4]

An aluminum-magnesium-silicon composite material (sintered body) was obtained by the same method as Example 1, except for the aspect of setting the added amount of aluminum to 6.11 parts by mass, and thus setting the content of aluminum in the starting material composition to 5.0 at%, in the mixing step.
It should be noted that the samples derived from the present Example are indicated by y=0.05 in FIGS. 6 to 9.

[Example 5]

An aluminum-magnesium-silicon composite material (sintered body) was obtained by the same method as Example 1, except for the aspect of setting the added amount of aluminum to 10.5 parts by mass, and thus setting the content of aluminum in the starting material composition to 10 at%, in the mixing step.
It should be noted that the samples derived from the present Example are indicated by y=0.10 in FIGS. 6 to 9.

[Example 6]

An aluminum-magnesium-silicon composite material (sintered body) was obtained by the same method as Example 1, except for the aspect of using a starting material composition in which 36.44 grams of high purity silicon and 63.58 grams of a magnesium alloy (AM60) containing aluminum were mixed to establish a compositional ratio of Mg to Si of Mg:Si = 66.0:33.0 and an Al content of 3.8 at%.

It should be noted that the samples derived from the present Example are indicated by y=0.038 in FIGS. 6 to 9.

[Example 7]

An aluminum-magnesium-silicon composite material (sintered body) was obtained by the same method as Example 1, except for the aspect of using a starting material composition in which 36.28 grams of high purity silicon and 63.75 grams of a magnesium alloy (AZ91) containing aluminum were mixed to establish a compositional ratio of Mg to Si of Mg:Si = 66.0:33.0 and an Al content of 5.8 at%.
It should be noted that the samples derived from the present Example are indicated by y=0.058 in FIGS. 6 to 9.

[Comparative Example 1]

A magnesium-silicon composite material (sintered body) was obtained by the same method as Example 1, except for the aspect of not having added aluminum in the mixing step.
It should be noted that the samples derived from the present Comparative Example are indicated by y=0 in FIGS. 6 to 9.

[Comparative Example 2]

An aluminum-magnesium-silicon composite material (sintered body) was obtained by the same method as Example 1, except for the aspect of setting the added amount of aluminum to 0.16 parts by mass, and thus setting the content of aluminum in the starting material composition to 0.15 at%, in the mixing step.
It should be noted that the samples derived from the present Comparative Example are indicated by y=0.0015 in FIGS. 6 to 9.

[Comparative Example 3]

An aluminum-magnesium-silicon composite material (sintered body) was obtained by the same method as Example 1, except for the aspect of setting the added amount of aluminum to 0.35 parts by mass, and thus setting the content of aluminum in the starting material composition to 0.33 at%, in the mixing step.
It should be noted that the samples derived from the present Comparative Example are indicated by y=0.0033 in FIGS. 6 to 9.

[Evaluation]

(Measurement of Seebeck Coefficient, Thermal Conductivity, and Electrical Conductivity)

The sintered bodies obtained in Examples 1 to 7 and Comparative Examples 1 to 3 were measured for the Seebeck coefficient $\alpha$, the thermal conductivity $\kappa$ and electrical conductivity $\sigma$ at operating temperatures of 330 to 860 K, and specially measured for electrical conductivity at 300 K, using a thermoelectric power and thermal conductivity measuring device ("ZEM2" manufactured by Ulvac Riko, Inc.) and a laser flash method thermal conductivity measuring device ("TC·7000H" manufactured by Ulvac Riko, Inc.). Based on the various parameters measured, the dimensionless figure-of-merit parameter ZT was calculated according to the above mathematical expression (1). The results are shown in Table 1 and FIGS. 6 to 9.

[Table 1]

|  | Thermoelectric characteristics at 860 K | | | | Electrical conductivity $\alpha$ at 300 K (S/cm) |
|---|---|---|---|---|---|
|  | ZT | $\alpha$ ($\mu$V/K) | $\sigma$ (S/cm) | $\kappa$ (W/cm*K) | |
| Example 1 | 0.66 | -252 | 403 | $3.33*10^{-2}$ | 1342 |
| Example 2 | 0.65 | -227 | 540 | $3.69*10^{-2}$ | 1551 |
| Example 3 | 0.63 | -225 | 502 | $3.47*10^{-2}$ | 1542 |
| Example 4 | 0.55 | -222 | 489 | $3.74*10^{-2}$ | 1430 |
| Example 5 | 0.47 | -243 | 390 | $4.22*10^{-2}$ | 1142 |
| Example 6 | 0.58 | -219 | 490 | $3.43*10^{-2}$ | 1480 |

(continued)

| | Thermoelectric characteristics at 860 K | | | | Electrical conductivity $\alpha$ at 300 K (S/cm) |
|---|---|---|---|---|---|
| | ZT | $\alpha$ ($\mu$V/K) | $\sigma$ (S/cm) | $\kappa$ (W/cm*K) | |
| Example 7 | 0.59 | -217 | 459 | $3.16*10^{-2}$ | 1420 |
| Comparative Example 1 | 0.18 | -256 | 108 | $3.4*10^{-2}$ | 189 |
| Comparative Example 2 | 0.37 | -276 | 229 | $4.1*10^{-2}$ | 807 |
| Comparative Example 3 | 0.28 | -171 | 251 | $2.29*10^{-2}$ | 974 |

It is found from Table 1 that thermoelectric conversion performance superior to the composite materials of Comparative Examples 1 to 3 was obtained for the aluminum-magnesium-silicon composite materials of Examples 1 to 7 having an Al content of 1 to 10 at% in the starting material composition. According to this result, it is found that the aluminum-magnesium-silicon composite material according to the present invention can be suitably employed as a thermoelectric conversion material.

Test Example 2: Evaluation of Plasticity

Following Test Example 1, aluminum-magnesium-silicon composite materials (sintered body) or magnesium-silicon composite materials (sintered body) were prepared from a starting material composition having 0.0 at%, 1.0 at%, 3.0 at%, 5.8 at% or 10 at% Al. Each of these sintered bodies was cut using a diamond wire saw, and the existence of cracks in the cross section after cutting was examined. Herein, samples in which a crack appeared were marked as X, and samples in which cracks did not appear were marked as O. The results are shown in Table 2.

[Table 2]

| Al compositional ratio (at%) | Plasticity |
|---|---|
| 0.0 | X |
| 1.0 | ○ |
| 2.0 | ○ |
| 3.0 | ○ |
| 5.8 | ○ |
| 10 | ○ |

It is found from Table 2 that the aluminum-magnesium-silicon composite material according to the present invention in which the content of Al in the starting material composition is 1 to 10 at% has superior plasticity compared to the magnesium-silicon composite materials. From this result, it is assumed that working of the aluminum-magnesium-silicon composite material according to the present invention into a thermoelectric conversion element would be easy.

Test Example 3: Evaluation of Compressive Strength

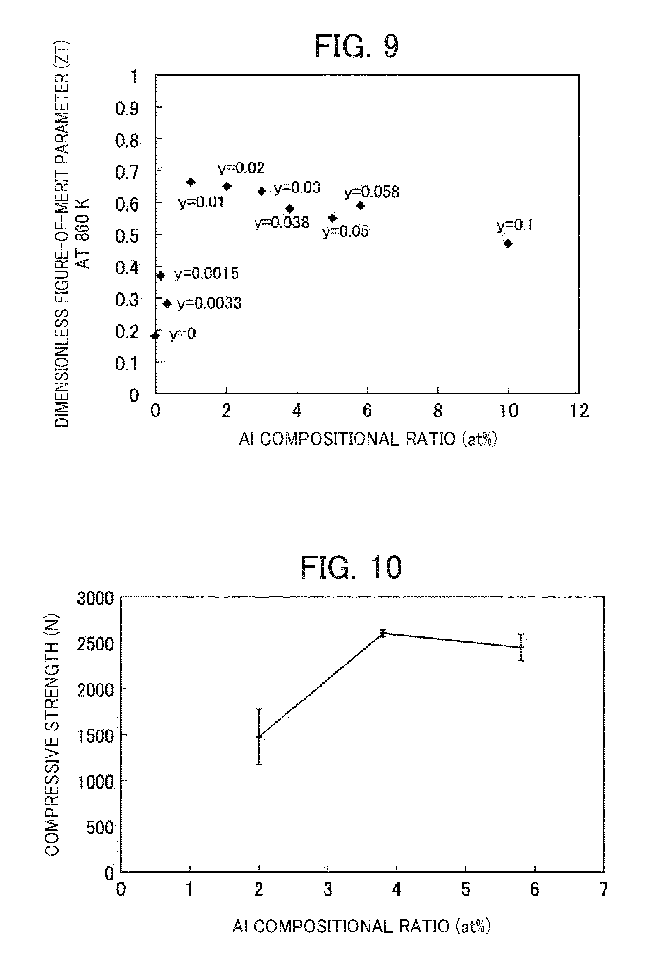

Following Examples 2, 6 and 7 of Test Example 1, aluminum-magnesium-silicon composite materials (sintered body) were prepared from a starting material composition of 2 at%, 3.8 at% or 5.8 at% Al. Each of these sintered bodies was cut to a size of 2.7 mm × 2.7 mm × 10 mm using a diamond wire saw, and the compressive strength (N) was measured using an Autograph ("AG-10TA" manufactured by Shimadzu Corporation). The testing rate at this time was 0.375 mm/min. It should be noted that measurement was performed four times to obtain the measured values of two points excluding the maximum value and minimum value, and the average value thereof. The results are shown in FIG. 10.
It is found from FIG. 10 that the compressive strength is particularly superior in the range in which the content of Al in the starting material composition is 3.5 to 6.0 at%. From this result, it is considered that, with the aluminum-magnesium-silicon composite material (sintered body) prepared using a starting material composition in which the content of Al is 3.5 to 6.0 at%, the element can be prevented from breaking upon cutting a sintered body with a blade saw to the desired size, for example.
It should be noted that, although not illustrated, the compressive strength declined when the content of Al in the starting material composition exceeded 6.0 at%.

INDUSTRIAL APPLICABILITY

The aluminum-magnesium-silicon composite material according to the present invention is an aluminum-magnesium-silicon composite material having high electrical conductivity that includes an alloy containing Al, Mg and Si. Herein, a material having high electrical conductivity $\sigma$ tends to also have a high dimensionless figure-of-merit parameter; therefore, according to the present invention, it is possible to obtain an aluminum-magnesium-silicon composite material excelling in thermoelectric conversion characteristics.

**Claims**

1. An aluminum-magnesium-silicon composite material comprising an alloy containing Al, Mg and Si, wherein the electrical conductivity $\sigma$ of the aluminum-magnesium-silicon composite material at 300 K is 1000 to 3000 S/cm.

2. The aluminum-magnesium-silicon composite material according to claim 1, synthesized from a starting material composition, which is obtained by mixing a Mg alloy containing Al and/or a mixture of Al and Mg with Si, and has a content of Al of 1 to 10 at%.

3. The aluminum-magnesium-silicon composite material according to claim 2, wherein the content of Al in the starting material composition is 3.5 to 6.0 at%.

4. A process for producing an aluminum-magnesium-silicon composite material, comprising a step of heating and melting a starting material composition, which is obtained by mixing a Mg alloy containing Al and/or a mixture of Al and Mg with Si, and has a content of Al of 1 to 10 at%, in a heat-resistant container including an opening portion and a lid portion covering the opening portion, wherein a contacting surface of an edge of the opening portion to the lid portion and a contacting surface of the lid portion to the opening portion have both been polished.

5. A thermoelectric conversion material, comprising the aluminum-magnesium-silicon composite material according to any one of claims 1 to 3.

6. A thermoelectric conversion element comprising:

   a thermoelectric conversion part; and
   a first electrode and a second electrode provided to the thermoelectric conversion part,
   wherein the thermoelectric conversion part is produced using the aluminum-magnesium-silicon composite material according to any one of claims 1 to 3.

7. A thermoelectric conversion module, comprising the thermoelectric conversion element according to claim 6.

8. A corrosion-resistant material, a light-weight structural material, a friction material, a ceramic substrate, a dielectric porcelain composition, a hydrogen storage composition, or a silane generator produced using the aluminum-magnesium-silicon composite material according to any one of claims 1 to 3.

## FIG. 1

## FIG. 2

# FIG. 3

HEAT

1035

Th

THERMOELECTRIC
CONVERSION
PART
103

1036

Tc

RADIATION

LOAD

(+) (−)

3

# FIG. 4

HEAT
ABSORBING

1035

Tc

THERMOELECTRIC
CONVERSION
PART
103

1036

Th

HEAT
GENERATING

POWER
SOURCE

(+) (−)

4

## FIG. 5

## FIG. 6

## FIG. 7

## FIG. 8

# FIG. 9

# FIG. 10

<div align="center">

**INTERNATIONAL SEARCH REPORT**

</div>

| | International application No. |
|---|---|
| | PCT/JP2010/062509 |

A. CLASSIFICATION OF SUBJECT MATTER
*H01L35/14*(2006.01)i, *C22C23/00*(2006.01)i, *H01L35/34*(2006.01)i, *H02N11/00* (2006.01)i

According to International Patent Classification (IPC) or to both national classification and IPC

B. FIELDS SEARCHED

Minimum documentation searched (classification system followed by classification symbols)
H01L35/14, C22C23/00, H01L35/34, H02N11/00

Documentation searched other than minimum documentation to the extent that such documents are included in the fields searched
Jitsuyo Shinan Koho           1922–1996     Jitsuyo Shinan Toroku Koho      1996–2010
Kokai Jitsuyo Shinan Koho     1971–2010     Toroku Jitsuyo Shinan Koho      1994–2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2002-194472 A  (Kanazawa Institute of Technology),<br>10 July 2002 (10.07.2002),<br>paragraph [0016](5)<br>(Family: none) | 1-4,8<br>5-7 |
| A | JP 2006-128235 A  (National Institute of Advanced Industrial Science and Technology),<br>18 May 2006 (18.05.2006),<br>entire text<br>(Family: none) | 1-8 |
| A | WO 2008/075789 A1  (Showa KDE Co., Ltd.),<br>26 June 2008 (26.06.2008),<br>entire text<br>& US 2010/0051081 A | 1-8 |

| ☒ | Further documents are listed in the continuation of Box C. | | ☐ | See patent family annex. |
|---|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 October, 2010 (13.10.10) | Date of mailing of the international search report<br>26 October, 2010 (26.10.10) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 461 384 A1**

<table>
<tr><th colspan="2">INTERNATIONAL SEARCH REPORT</th><th>International application No.<br>PCT/JP2010/062509</th></tr>
<tr><td colspan="3">C (Continuation). DOCUMENTS CONSIDERED TO BE RELEVANT</td></tr>
<tr><td>Category*</td><td>Citation of document, with indication, where appropriate, of the relevant passages</td><td>Relevant to claim No.</td></tr>
<tr><td>A</td><td>WO 99/022411 A1 (Sumitomo Special Metals Co., Ltd.),<br>06 May 1999 (06.05.1999),<br>entire text<br>& EP 1039557 A1 & US 6506321 B1</td><td>1-8</td></tr>
<tr><td>A</td><td>JP 2005-129765 A (Hitachi Metals, Ltd.),<br>19 May 2005 (19.05.2005),<br>entire text<br>(Family: none)</td><td>1-8</td></tr>
</table>

Form PCT/ISA/210 (continuation of second sheet) (July 2009)

<table>
<tr><td>**INTERNATIONAL SEARCH REPORT**</td><td>International application No.<br>PCT/JP2010/062509</td></tr>
</table>

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:

The matter set forth in claim 1 is not novel, since the matter is described in the document 1 (JP 2002-194472 A (Kanazawa Institute of Technology), 10 July 2002 (10.07.2002), paragraph [0016] (5)).
   Therefore, claims 1 – 8 do not have a common matter which is a special technical feature in the meaning of the second sentence of PCT Rule 13.2, and consequently do not comply with the requirement of unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**     ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H11274578 B
- JP 2005314805 A

- WO 03027341 A

### Non-patent literature cited in the description

- Semiconducting Properties of Mg2Si Single Crystals. *Physical Review,* 15 March 1958, vol. 109 (6), 1909-1915
- Seebeck Effect in Mg2Si Single Crystals. *J. Phys. Chem. Solids Program Press,* 1962, vol. 23, 601-610

- Bulk Crystals Growth of Mg2Si by the Vertical Bridgeman Method. *Science Direct Thin Solid Films,* 2004, vol. 461, 86-89